# EUROPEAN PATENT APPLICATION

(11) **EP 4 535 380 A1**
(43) Date of publication of application: **09.04.2025**
(21) Application number: 24203547.5
(22) Date of filing: 30.09.2024
(51) Int. Cl.: H01F 38/14, H01F 27/28, H05K 1/02

(54) **WIRELESS POWER TRANSFER ASSEMBLY AND SYSTEM**

(30) Priority: 05.10.2023 US 202363542695 P; 05.10.2023 US 202363542673 P; 26.09.2024 US 202418897388
(71) Applicant: Delta Electronics, Inc., Neihu, Taipei 11491 (TW)
(72) Inventor: Anurag, Anup, Durham, NC 27709 (US); Zhang, Chi, Durham, NC 27709 (US); Wang, Ruxi, Durham, NC 27709 (US); Barbosa, Peter Mantovanelli, Durham, NC 27709 (US)
(74) Representative: Uexküll & Stolberg

(57) **Abstract**

The present disclosure provides a wireless power transfer system (10) and a wireless power transfer assembly (62a). In one aspect, a wireless power transfer assembly (62a) includes a flexible printed circuit board (66, 28), which is also referred to as a flexible printed circuit board structure. The flexible printed circuit board (66, 28) includes a litz winding (30). The litz winding (30) has multiple layers (32a, 32b, 32c, 32d) of electrically insulated strands (38). The wireless power transfer assembly (62a) also includes a ceramic heat sink (64). The ceramic heat sink (64) is arranged relative to the flexible printed circuit board (66) in a manner that dissipates heat away from the litz winding. In another aspect, a wireless power transfer system (10) includes a transmit unit (12) or receive unit (14) having an input stage (15), a resonator (16), and an assembly (62a). The assembly (62a) includes a flexible printed circuit board (66, 28) having a litz winding (30). The litz winding (30) has multiple layers (32a, 32b, 32c, 32d) of electrically insulated strands (38). The assembly (62a) also includes a ceramic heat sink (64) arranged relative to the flexible printed circuit board (66) in a manner that dissipates heat away from the litz winding.

## Description

### FIELD OF THE INVENTION

The present invention relates to a thermal solution for transferring heat from a heat source like a winding or power converter to the environment, and more particularly, to an assembly for printed circuit board (PCB) based winding structures that implement the thermal solution.

### BACKGROUND OF THE INVENTION

With the advancement of wide bandgap semiconductors, power devices such as MOSFETs and IGBTs, which can switch at high frequencies, are becoming accepted in the industry. The use of these devices is opening up new application areas for high frequency power conversion, which includes, but is not limited to, electric vehicle charging infrastructures, renewable energy integration, active filters, and solid-state transformers.

Specifically, in the area of electric vehicle charging, wireless power transfer (WPT) has gained a lot of traction in recent years, especially for delivery trucks or other short haul vehicles, which may have a predefined route. The increasing interest in wireless power transfer is due, at least in part, to its inherent advantages of reduced labor costs, programmability to charge during off peak hours, and more importantly, operational safety during charging.

For the wireless charging applications, such as in electric vehicle charging, typically the converters are run at high frequencies (e.g., approximately 100 kHz to 200 kHz) and, for high power applications, the charging pad may be made using conventional litz wiring structures (see, e.g., Sun, Y. Xu, J. Wang, R. Burgos and D. Boroyevich, "Insulation Design of Wireless Auxiliary Power Supply for Medium Voltage Converters," in IEEE Journal of Emerging and Selected Topics in Power Electronics, vol. 9, no. 4, pp. 4200-4211, Aug. 2021, doi: 10.1109/JESTPE.2020.3011075). Litz wiring or wires are typically preferred for these applications, owing at least in part to lower losses while carrying high frequency currents. In high power applications, where large high frequency currents are conducted, conventional litz wires are used for making the coils, and many coils are used in parallel to reach the desired power. While the use of litz wires minimizes alternating current (AC) losses, the manufacturing process for litz wire structures is challenging, and scaling up in power is not straightforward. For instance, attempts to increase the power rating through parallel connections of a large number of WPT coils may be impractical due in part to variations in coupling coefficients for each coil set, which may result in circulating currents and/or significant inductive impedance mismatches. Also, for high power density applications, conventional litz wire based winding approaches pose limitations. For instance, along with the increased size, litz wire manufacturing typically involves a manual process for assembly, which makes it cumbersome and difficult to manufacture on a larger scale.

To overcome one or more of the challenges of conventional litz wire approaches, printed circuit board (PCB) based solutions have been provided, which offer more repeatability and ease of manufacturing. However, even with PCB based solutions, challenges still exist. For instance, there is a certain amount of power loss associated with the winding structure itself, and it is important to transfer the heat from the structure to keep the temperature of the winding at reasonable levels.

Additionally, existing thermal solutions also have some shortcomings. For instance, the coil or winding(s) are often cooled using natural air or forced cooling, where the heat is dissipated directly from the winding structure by blowing air over the winding structure, or simply by natural convection. However, for applications where the coil carries higher currents, the thermal dissipation surface of the coil itself may not be sufficient to dissipate the heat. Some approaches use a ferrite core to dissipate the heat. For instance, ferrite cores are often used to shape the magnetic field lines, and ferrite cores are a good conductor of heat. However, the presence of the ferrite structure may limit the air flow to the coil, and may lead to insufficient or sub-optimal cooling of the coil in the case of natural or forced air cooling. Further still, some approaches add a metal heat sink, sandwiched between the PCB based winding structure and the ferrite core, or separated from the PCB based winding structure by the ferrite core. The heat sink facilitates heat dissipation, which in the latter case permits a thermal path from the coil, through the ferrite core, and to the heat sink. The addition of the metal heat sink helps in the reduction of the total thermal resistance in the path, while helping to maintain the temperature of the winding structure. In some instances, the heat sink itself may be cooled either by natural convection or forced air cooling. In structures where the heat sink is sandwiched in between the PCB based winding structure and the ferrite core, the heat from the winding structure, which represents a major heat source, is directly connected to the heat sink, which offers less thermal resistance and better cooling capability when compared to the structure described above where the heat sink is the end recipient of the heat flow. An additional benefit to this arrangement is that the direct connection between the ferrite core and the heat sink helps in cooling the ferrite core. Hower, a challenge to the use of the metal heat sink is that the magnetic field generated by the winding is not shielded from the metal heat sink, which may cause eddy currents that lead to additional current and losses (which may lead to insufficient or sub-optimal cooling and decreased efficiency).

### SUMMARY OF THE INVENTION

In accordance with an aspect of the present disclosure, there is provided a wireless power transfer assembly and system for charging an electric vehicle.

In one aspect, the wireless power transfer assembly includes a flexible printed circuit board and a ceramic heat sink. The flexible printed circuit board includes a litz winding, and the litz winding has multiple layers of electrically insulated strands. The ceramic heat sink is arranged relative to the flexible printed circuit board in a manner that dissipates heat away from the litz winding.

In another aspect, the wireless power transfer system includes a transmit unit or receive unit having an input stage, a resonator, and an assembly. The assembly includes a flexible printed circuit board and a ceramic heat sink. The flexible printed circuit board has a litz winding, and the litz winding has multiple layers of electrically insulated strands. The ceramic heat sink is arranged relative to the flexible printed circuit board in a manner that dissipates heat away from the litz winding.

These and other aspects of the invention will be apparent from and explained with reference to the embodiment(s) described hereinafter.

### BRIEF DESCRIPTION OF THE DRAWINGS

Many aspects of the embodiments of the present invention can be better understood with reference to the following drawings, which are diagrammatic. The components in the drawings are not necessarily to scale, emphasis instead being placed upon clearly illustrating the principles of the embodiments of the present invention. Moreover, in the drawings, like reference numerals designate corresponding parts throughout the several views.
FIG. 1A is a block diagram that shows an example wireless power transfer system, in accordance with an embodiment of the invention.
FIG. 1B is a schematic diagram that shows a portion of the wireless power transfer system of FIG. 1A that includes a mechanism for wireless power transfer, in accordance with an embodiment of the invention.
FIG. 2 is a schematic diagram that shows an example printed circuit board (PCB) based litz winding structure used for the wireless power transfer depicted in FIG. 1A, in accordance with an embodiment of the invention.
FIG. 3 is a schematic diagram that shows, in fragmentary, cross-sectional, side elevation view, an example flex PCB based litz winding structure where the litz winding emulates a non-PCB based litz wiring arrangement, in accordance with an embodiment of the invention.
FIG. 4A is a schematic diagram that shows, in perspective view, an example litz winding arrangement for a flex PCB based litz winding structure, in accordance with an embodiment of the invention.
FIG. 4B is a schematic diagram that shows, in fragmentary, side elevation view, an example litz winding arrangement for a flex PCB based litz winding structure, in accordance with an embodiment of the invention.
FIG. 5A is a schematic diagram that shows, in a fragmentary, perspective view, an example two-layer flex PCB based litz winding structure where the litz winding emulates a non-PCB based, spiral wound litz wiring arrangement, in accordance with an embodiment of the invention.
FIG. 5B shows the example two-layer flex PCB based litz winding structure of FIG. 5A along with insulating material, shown in transparent view, that electrically insulates the layers, in accordance with an embodiment of the invention.
FIG. 6 is a chart diagram that shows an example of total losses in an example rigid PCB based litz winding structure and a flex PCB based litz winding structure for a current of 150 A and different frequencies, in accordance with an embodiment of the invention.
FIG. 7 is a chart diagram that shows an example of percentage reduction of losses in the flex PCB based litz winding structure as compared to the rigid PCB based litz winding structure associated with FIG. 6, in accordance with an embodiment of the invention.
FIG. 8 is a schematic diagram that shows an example wireless power transfer (WPT) assembly where a ceramic heat sink is disposed beneath and adjacent to the flex PCB based litz winding structure, in accordance with an embodiment of the invention.
FIG. 9 is a schematic diagram that shows an example WPT assembly where a ceramic heat sink is disposed above and adjacent to the flex PCB based litz winding structure, in accordance with an embodiment of the invention.
FIG. 10 is a schematic diagram that shows an example WPT assembly where the flex PCB based litz winding structure is sandwiched between ceramic heat sinks disposed above and beneath, and adjacent to, the flex PCB based litz winding structure, in accordance with an embodiment of the invention.
FIG. 11A is a schematic diagram that shows an example assembly where a ceramic heat sink is disposed between a PCB based litz winding structure and a ferrite core, in accordance with an embodiment of the invention.
FIG. 11B is a schematic diagram that shows an example thermal resistance network of the example assembly of FIG. 11A.
FIG. 12A is a schematic diagram that shows an example assembly where a ceramic heat sink is disposed away from a PCB based litz winding structure and connected to a ferrite core, in accordance with an embodiment of the invention.
FIG. 12B is a schematic diagram that shows an example thermal resistance network of the example assembly of FIG. 12A.
FIG. 13A is a schematic diagram that shows an example assembly where a ceramic heat sink is directly connected to a PCB based litz winding structure away from a ferrite core, in accordance with an embodiment of the invention.
FIG. 13B is a schematic diagram that shows an example thermal resistance network of the example assembly of FIG. 13A.
FIG. 14A is a schematic diagram that shows an example assembly where a ceramic heat sink is directly connected to a side of a PCB based litz winding structure away from a ferrite core and another ceramic heat sink is connected to the other side of the PCB based litz winding structure, in accordance with an embodiment of the invention.
FIG. 14B is a schematic diagram that shows an example thermal resistance network of the example assembly of FIG. 14A.
FIG. 15 is a schematic diagram that shows an example assembly where a PCB based litz winding structure is enclosed in a ceramic heat sink and directly connected to the ceramic heat sink, in accordance with an embodiment of the invention.
FIG. 16 is a schematic diagram that shows an example assembly where a PCB based litz winding structure is enclosed in a ceramic heat sink and directly connected to a ferrite core, in accordance with an embodiment of the invention.
FIG. 17 is a schematic diagram that shows an example assembly where a ceramic heat sink is integrated into a PCB based litz winding structure, in accordance with an embodiment of the invention.

### DETAILED DESCRIPTION OF THE PREFERRED EMBODIMENT

Certain embodiments of a system and assembly, that includes a printed circuit board (PCB) based litz winding or coil structure and ceramic heat sink are disclosed that facilitate the dissipation of heat from heat sources within and proximal to the assembly. In one embodiment, the assembly is used in a wireless power transfer (WPT) system that may be used for, say, charging an electric vehicle, and includes a flexible printed circuit board (flex PCB) that includes a litz winding or coil. The coil includes multiple layers of strands. In one embodiment, the strands may be configured as plural, electrically insulated conductive traces that are also connected across multiple layers to emulate non-PCB based litz wire. For instance, each strand among the multiple strands in a single layer is an electrically insulated, conductive trace (e.g., annealed copper trace) that is series-connected (e.g., using vias) between layers to emulate the helical or spiral pattern of a traditional litz wiring arrangement. Further, the assembly includes a ceramic heat sink that is arranged relative to the flex PCB based litz winding structure in a manner that dissipates heat away from the coil.

Digressing briefly, existing PCB based litz winding solutions reduce high frequency AC losses (as compared to conventional copper conductors) by emulating a (non-PCB based) litz wire, where the litz winding is included with the PCB structure and is divided into many individual strands (e.g., each strand in a given layer is series-connected to a strand in another layer using a via) and then weaving the individual strands among the multiple layers in the same manner as a conventional litz wire structure. As noted above, such a structure emulates a (non-PCB based) litz wire (and behavior), except instead of conventional litz wire, does so on a PCB structure. This emulation of litz wire on a PCB structure helps in reducing AC losses as compared to existing PCB based structures. Additional information on the use of PCB based litz winding structures may be found in I. Lope, J. Acero, J. M. Burdio, C. Carretero and R. Alonso, "Design and Implementation of PCB Inductors With Litz-Wire Structure for Conventional-Size Large-Signal Domestic Induction Heating Applications," in IEEE Transactions on Industry Applications, vol. 51, no. 3, pp. 2434-2442, May-June 2015, doi: 10.1109/TIA.2014.2382758. See also, U.S. Patent No. 7,973,635 B2. One shortcoming to existing structures is that each strand uses a minimum of two layers of the PCB to achieve the desired effect. While this is a good technique to reduce the AC losses, extracting the heat from inner layers of the PCB is still challenging since PCB insulating materials typically do not have a good thermal conductivity (typically in the range of 0.3 to 0.6 W/mK) and also because of the minimum layer-to-layer thickness (e.g., being in the range of 10 mils). It is also difficult to reduce dielectric thickness, since reducing the thickness increases the risk of cracking (and hence, may create reliability issues). Due to the thickness of the insulating material often used in these existing approaches (e.g., FR4 material), it is infeasible to operate the winding structure at higher power given the difficulty in extracting the heat generated in the PCB winding(s).

Also, existing thermal solutions pose challenges, as explained above. For instance, metal heat sinks offer good thermal performance and relative ease in manufacturability, yet are electrically conductive. Accordingly, whether a solution is used where the metal heat sink is sandwiched between the PCB winding structure and the ferrite core, or a solution is used where the ferrite core is sandwiched between the PCB winding structure and the metal heat sink, these solutions do not provide any electrical isolation. For applications where electrical isolation is important, additional insulating material may need to be inserted between the heat source, which may induce additional thermal resistance and degrade cooling performance. These challenges may increase when scaling up for applications with increased power.

In contrast, certain embodiments of systems and assemblies including a PCB based litz winding structure and ceramic heat sink are disclosed that combine the heat dissipation effects resulting from a reduced thickness of the flexible PCB structure and a ceramic heat sink to overcome some of the thermal cooling challenges faced when using existing PCB structures, while providing for electrical isolation that existing metal heat sinks cannot provide.

Having summarized certain features of assemblies, each including a PCB based litz winding structure and ceramic heat sink, of the present disclosure, reference will now be made in detail to the description of the assemblies as illustrated in the drawings. While the disclosed assemblies will be described in connection with these drawings, with emphasis on a flexible or flex PCB based litz winding structure with a ceramic heat sink for wireless power transfer applications, and more specifically, for wireless electric vehicle charging applications, there is no intent to limit it to the embodiment or embodiments disclosed herein. For instance, some embodiments of PCB based litz winding assemblies may use a rigid PCB based litz winding structure with a ceramic heat sink. For instance, rigid PCB based litz winding assemblies may include a core (e.g., ferrite core), such as for wired applications. Further, although the description identifies or describes specifics of one or more embodiments, such specifics are not necessarily part of every embodiment, nor are all of any various stated advantages necessarily associated with a single embodiment. On the contrary, the intent is to cover alternatives, modifications and equivalents included within the principles and scope of embodiments of the disclosure as defined by the appended claims. For instance, two or more embodiments may be interchanged or combined in any combination. Further, it should be appreciated in the context of the present disclosure that the claims are not necessarily limited to the particular embodiments set out in the description.

In the description that follows, reference to a PCB based litz winding assembly may include a rigid or flex PCB structure unless the description is specifically limited to one or the other, and may include a ferrite core, or not include a ferrite core, as explained further below. Further, reference to a PCB based litz winding structure is understood to refer to a PCB and a litz winding or coil that is arranged on the PCB to emulate existing litz wiring (e.g., litz wiring for non-PCB implementations). The terms wiring or wires are used herein to refer to the existing, non-PCB based litz wiring approaches, and the terms coil, winding or windings are used to refer to PCB-based winding arrangements that emulate the non-PCB based litz wiring configurations and functionality. Although certain figures of the different assemblies are shown without the ceramic heat sink, it should be understood that a ceramic heat sink is contemplated to be used in any one of the depicted PCB based litz winding structures.

It is further noted that the terms coil, winding(s) or winding structure, and the like are used interchangeably throughout the disclosure.

As noted above, certain embodiments of assemblies (e.g., WPT assemblies) are disclosed that may combine the heat dissipation benefits of a flex PCB structure and a ceramic heat sink disposed relative to the flex PCB structure. For instance, a flex PCB based litz winding structure, which may be used for power transfer, offers low losses and good thermal conductivity, along with having a good manufacturability as compared to existing rigid PCB based litz winding designs or non-PCB based litz wire designs. A flex PCB based litz winding structure may limit the temperature of the copper winding structure to improve the thermal performance and allow higher current operation. Further, a ceramic heat sink provides a thermal solution that enables efficient heat transfer from a heat source (e.g., the winding and/or ferrite core, where applicable, and even heat sources of other components that are proximal (e.g., co-located, or brought temporarily into proximity) to the assembly), where the position of the ceramic heat sink may be manipulated based on design requirements. The ceramic heat sink further provides electrical insulation, while improving the thermal dissipation (compared to metal heat sinks). For instance, the ceramic heat sink may be directly attached to the windings (e.g., the windings may be pressed against the ceramic heat sink, using for example, a thermally-conductive paste) without a need for insulation (e.g., no insulation or gap between the windings and the heat sink), which may reduce thermal resistance between the windings and the ceramic heat sink. Also, the ceramic heat sink enables a direct connection to both the winding and, where applicable, the ferrite core, without generating additional losses while effectively cooling both structures.

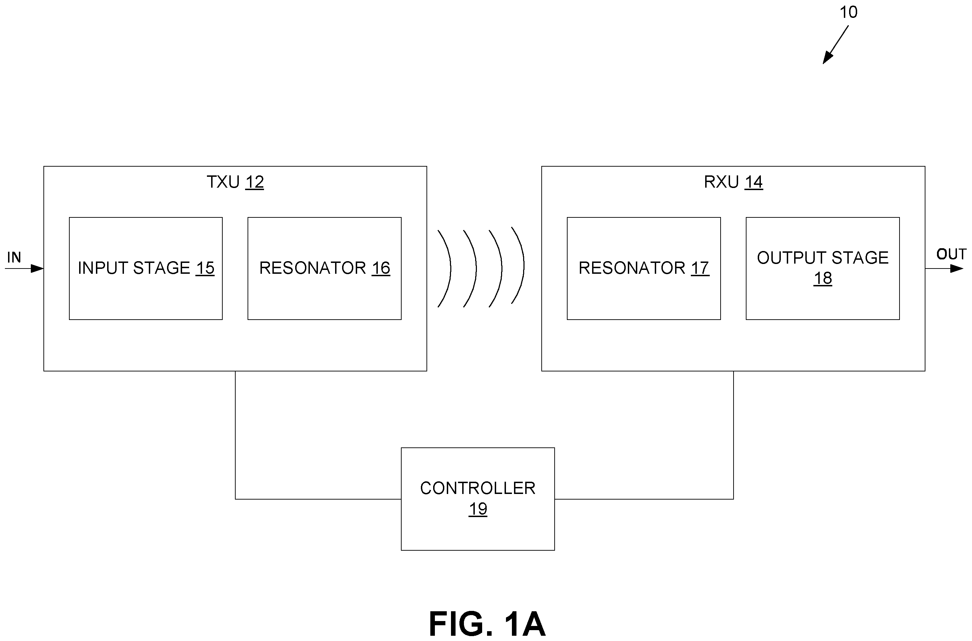

FIG. 1A is a block diagram that shows an embodiment of an example wireless power transfer (WPT) system 10. The WPT system 10 may be used for electric vehicle charging, among other applications involving wireless power transfer, particularly in high power, high frequency applications. The WPT system 10 includes a transmitting unit (TXU) 12 and a receiving unit (RXU) 14. The transmitting unit 12 may reside in a charging station (e.g., a retail or public charging station) or charging pad (e.g., residing in a garage of a homeowner) for an electric vehicle. The receiving unit 14 may reside in an electric vehicle. In the depicted embodiment, the transmitting unit 12 includes an input stage 15 and a resonator 16.

The input stage 15 receives input power and converts the input power into a suitable AC power for use by the resonator 16. For instance, the input stage 15 may be connected to an AC power source providing, for instance, AC input power. In one embodiment, the input stage 15 includes functionality for AC/DC, DC/DC, and DC/AC conversion. For instance, an AC/DC converter may convert the AC input power to a fixed DC intermediate power (e.g., 800V), which is then converted by the DC/DC converter to a variable DC intermediate power (e.g., 0 - 800V). The variable DC intermediate power may be fed to an inverter (e.g., which includes plural switches that are manipulated to control duty cycle and frequency). In some embodiments, the DC/DC conversion may be omitted.

The resonator 16 includes a tuned circuit (e.g., with a resistor, a capacitor, and a PCB based coil connected in series). By applying an AC power to the input of the resonator 16, the resonator 16 starts oscillating, thereby inducing a magnetic field that is emitted into a zone around the resonator 16. In some instances, a ferrite core may be used (e.g., in non-WPT applications) to direct the magnetic field into a direction as desired by the particular application.

The receiving unit 14 includes a resonator 17 and an output stage 18. The resonator 17 picks up the magnetic field generated by the resonator 16 and converts the power received through the magnetic field into an AC output. The resonator 17 largely corresponds to the resonator 16, and essentially also includes a tuned circuit with a resistor, a capacitor, and a PCB based coil connected in series. By properly arranging the resonator 17 within the magnetic field produced by the resonator 16, it may pick up the energy transferred via the magnetic field and convert it to an AC output power. Similar to the resonator 16, the resonator 17 may also include a ferrite core in some embodiments.

The output stage 18 receives the AC output of the resonator 17 and converts the AC output to a DC output, which is then provided as output power for a given load (e.g., to charge an electric vehicle battery). For instance, the output stage 18 may include an AC/DC converter that is connected to the output of the resonator 17. The AC/DC converter converts the AC power received at its input to a DC output power. The AC/DC converter may include a synchronous rectifier, followed by a bulk capacitor and an output filter to shape the DC output power.

The controller 19 controls the power transfer from the transmitting unit 12 to the receiving unit 14 over the air gap and, accordingly, to a load connected to the output stage 18 (e.g., to meet the requirements of a particular application, such as to meet a certain output power needed by a device connected to the output stage 18). For instance, where the load includes a battery to be charged by the wireless power transfer system 10, the controller 19 may receive a power set value from the load, for example a current set value from a battery management system (BMS) of the load battery. The controller 19 (or a separate controller in communication with the controller 19) may include functionality for current sensing (e.g., to measure the AC output from the resonator 17, or DC output from the output stage 18). The controller 19 may use the sensed current (and the current set value) to generate control signals that control the transmitting unit 12 (e.g., such as to induce a magnetic field to meet the required output power).

The transmitting unit 12 and receiving unit 14 may also include additional functionality, such as a communications interface (not shown), where the communications interface may facilitate coordination (e.g., for charging applications) among the various systems or devices (e.g., between a battery management of the battery and the WPT system 10). Note that the circuitry of the transmitting unit 12 and receiving unit 14 may be implemented using digital, analog, or mixed signal electronics embodied in one or more processors (digital signal processors), logic gates, etc. As the make-up of such circuitry is known to those having ordinary skill in the art, further discussion of the same is omitted here for brevity.

Note that in some embodiments, functionality of the input stage 15 and resonator 16 may be combined in a single PCB, or distributed among plural PCB structures. Similarly, functionality of the output stage 18 and resonator 17 may be combined in a single PCB, or distributed among plural PCB structures.

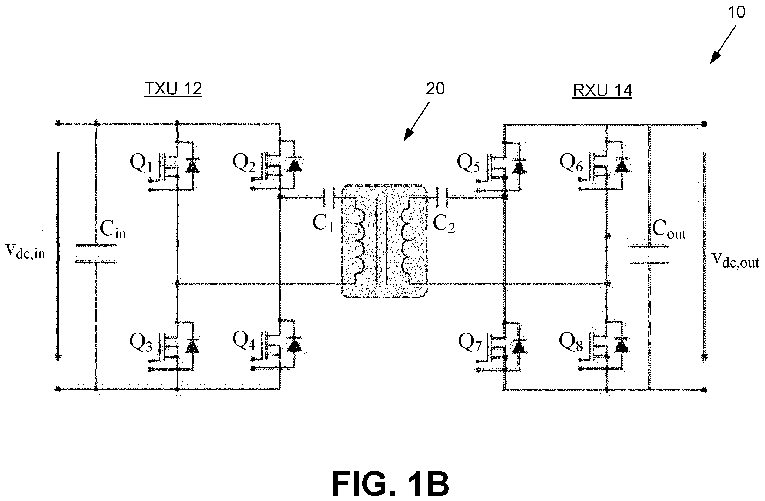

Also shown in FIG. 1B are example components of the WPT system 10 of FIG. 1A, and with emphasis on a wireless power transfer (WPT) coil system 20, which schematically represents a transmitting unit coil and receiving unit coil of respective resonators 16 and 17. For instance, high frequency current flowing through the transmitting unit coil creates a magnetic field, which emanates into the air and passes through the receiving unit coil, which in turn generates current in the receiving unit coil that is ultimately used to charge the electric vehicle.

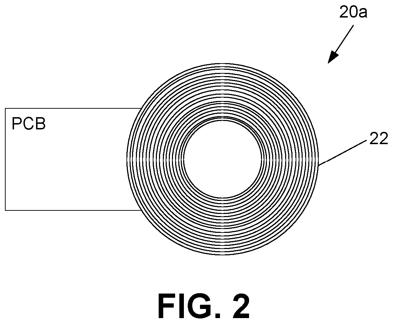

FIG. 2 shows an example flex printed circuit board (PCB) based litz winding structure 20a used for wireless power transfer (e.g., for functionality involved with the WPT coil system 20 of FIG. 1B, and in particular, to the transmitting side PCB based coil of the resonator 16, though the description below is also applicable to the receiving side PCB based coil of the resonator 17). In the depicted example, the flex PCB based litz winding structure 20a includes a flexible PCB that includes a litz winding 22. The litz winding 22 comprises multiple strands or traces (e.g., plural, series connected, electrically insulated traces) that may be arranged in multiple layers to emulate non-PCB based litz wire, as described further below. Though shown with a circular geometry, the litz winding 22 may be configured in other shapes (e.g., rectangular shape) in some embodiments.

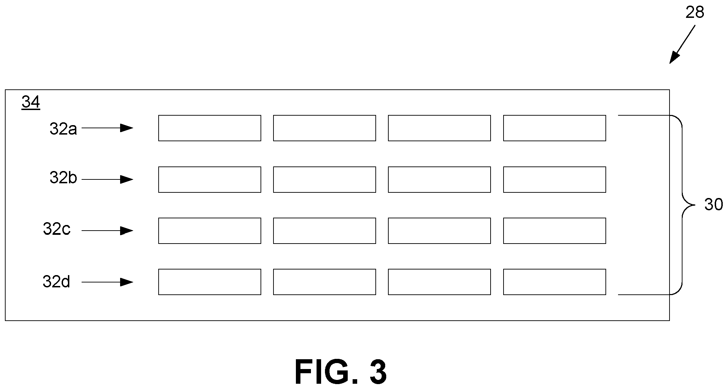

FIG. 3 shows an embodiment of an example flex PCB based litz winding structure 28. The flex PCB based litz winding structure 28 includes a litz winding 30 that emulates a (non-PCB based) litz wire. The flex PCB based litz winding structure 28 may be the same or similar to the flex PCB based litz winding structure 20a shown in FIG. 2. The litz winding 30 in this example is shown with multiple layers 32 (e.g., 32a, 32b, 32c, and 32d). Though four layers are shown, other quantities of layers may be used (e.g., two layers to fifteen layers, though not limited to this range). Digressing briefly, though the greater the number of layers (generally), the better the performance, the choice of quantity of layers may be a function of one or more of power requirements, manufacturability, and cost. For instance, a quantity of fifteen layers provides excellent performance, though is more difficult to manufacture (and hence costly) than a smaller quantity of layers, and may in fact not be needed for low cost applications. The layers 32 are electrically insulated from one another by a flexible insulating layer 34. In one embodiment, the distance between layers (or equivalently, the thickness of the flexible insulating layer 34 disposed between the layers 32) may be from approximately 1 mil to 10 mils. Further, the distance between the outer layers 32 and a respective edge of the flex PCB based litz winding structure 28 (or the thickness of the flexible insulating layer 34 between each outer layer 32a, 32d and an edge of the flex PCB based litz winding structure 28) may be from approximately 1 mil to 10 mils (though not necessarily limited to being of the same dimension between layers and from outer layer to edge). The non-conductive material of the flex PCB based litz winding structure, or rather, the flexible insulating layer 34 (e.g., the PCB structural material), may be comprised of polyester, adhesive polyamide, or adhesiveless polyamide, though other flexible insulating material may be used in some embodiments. The choice of which insulating material to use may be based upon the intended application. In comparison, rigid PCB based litz winding structures are typically made from different kinds of polyamide, such as FR4, which are rigid and hence break when bent (e.g., for a bend of the same radius, breaks before a flex PCB breaks). The rigid PCB based litz winding structures typically have an insulating material thickness between layers of 10 mils or more, which also adds to the rigidity, particularly as the number of layers increases. Also, the thickness of the rigid PCB based litz winding structures makes it difficult to dissipate heat, particularly for the inner layers. The smaller insulating material thickness for the flex rigid PCB based litz winding structures 28 enables a better thermal conductive path, as compared to a rigid PCB based litz winding structures, and is able to dissipate more heat as compared to a rigid PCB based litz winding structure. The litz winding 30 is also made of a flexible, conductive material, including a metal conductive material such as annealed copper, which is bendable, or non-metal conductive material (e.g., made with graphene material).

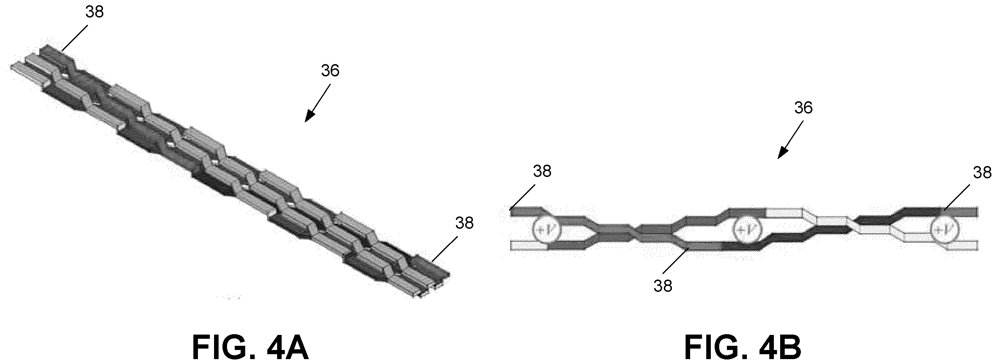

FIGS. 4A-4B show an example litz winding arrangement 36 for a flex PCB based litz winding structure (e.g., flex PCB based litz winding structure 28 of FIG. 3 or 20a of FIG. 2). The litz winding arrangement 36 provides a technique to reduce high frequency AC losses by dividing a conductor (e.g., copper conductor) in the flex PCB based litz winding structure into many individual strands or traces that collectively are referred to as a bundle, resulting in an arrangement that emulates existing litz wire structures. Note that a strand includes a continuous, conductive trace that may be connected in series to another single trace using a via. Referring to FIG.4A, three individual strands make up a bundle (or single turn) in this example, and each strand is electrically isolated from the others (e.g., from the intervening insulating material of the PCB structure). As explained further below, following the path of one of the strands, strand 38, from left to right in FIG. 4A reveals a spiral or helical winding arrangement, where the strand 38 begins at one layer and extends along an angle, or similarly stated, crosses a width of the bundle along a plane (the first layer). Then, upon crossing the width of the bundle and reaching a via (not shown), the via allows the strand to continue on another level, crossing the width of the bundle along a second plane until reaching another via, which enables the strand to return to the top or initial layer. In this way, a first segment may be understood as the length of the strand 38 along the first layer in one direction, and a second segment is the length of the strand 38 along the second layer in another direction, with the via enabling a series connection between layers. A similar pattern is used for the other strands of the bundle. In this way, the strand 38 (like the other strands) follows a spiral or helical pattern, which emulates existing litz wiring both in structure and function. Each of the strands passes through a specific position in the bundle so that all the strands or windings are spatially equivalent. As shown in FIG. 4B, shown is an induced voltage (+V) between a pair of strands or traces. It should be noted that for flex PCB based litz winding structure, the litz winding arrangement 36 may take on different shapes and structures as needed, since the flex PCB based litz winding structure provides higher flexibility as compared to rigid PCB based litz winding structures.

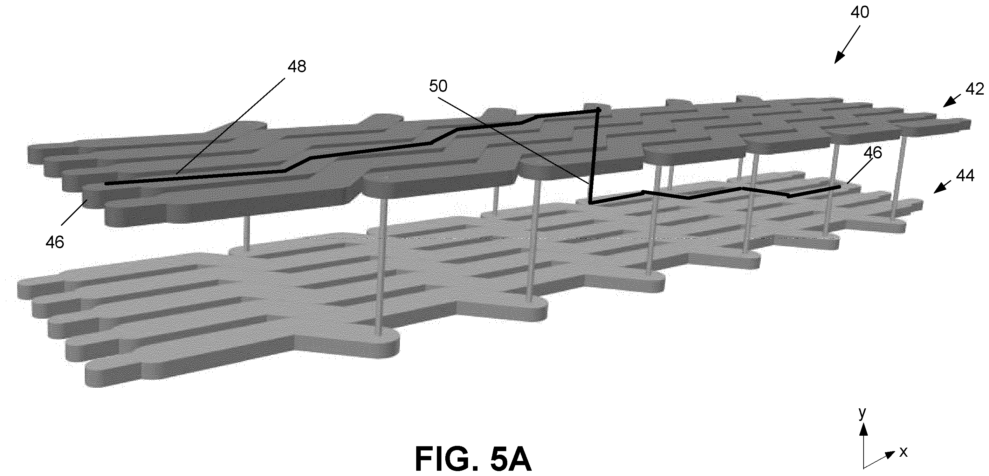

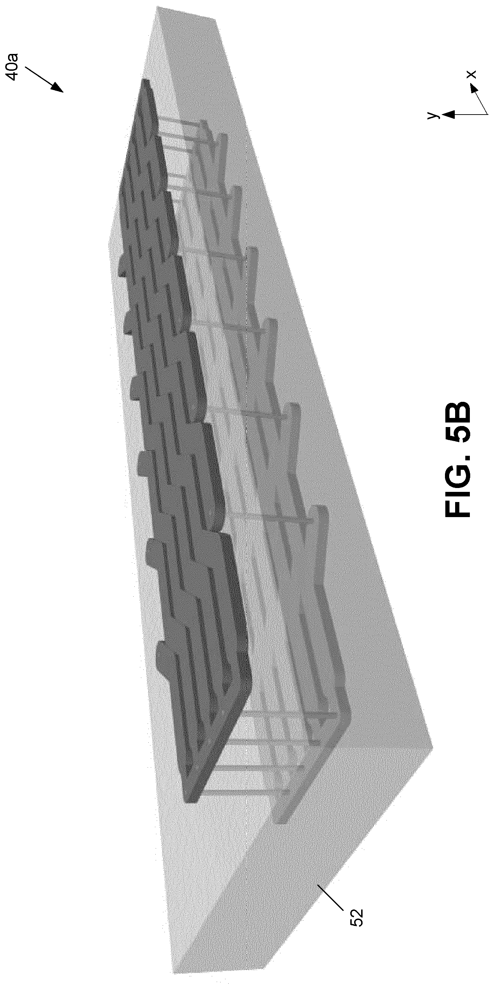

FIG. 5A shows an example of a two-layer flex PCB based litz winding structure 40 that emulates a spiral wound litz wire. The two-layer flex PCB based litz winding structure 40 may be used for, or extended to be used for, any of the flex PCB based litz winding structures disclosed above (or below). The two-layer flex PCB based litz winding structure 40 includes a first layer 42 of strands or traces and a second layer 44 of strands or traces, as well as an intervening flexible insulating layer (not shown) as described below in association with FIG. 5B. In this example, there are five, electrically isolated (e.g., by an intervening insulating material not shown in FIG. 5A) strands, with one of the strands 46 traced by an overlaying bold line 48 to show the spiral wound nature of the strands. Note that fewer or a greater number of strands may be used in some embodiments. As similarly described for the litz winding arrangement 36 of FIGS. 4A-4B, the strand 46 is shown (by the overlaid bold line 48) arranged in a manner that spans across the width of the bundle of strands along the first layer 42 until reaching a via 50 (the vias obscured by the bold line but similar in structure to the other vias shown in FIG. 5A). The via 50 enables a conductive connection (e.g., series connection) between the first and second layers 42 and 44, and in this example, permits the strand 46 to effectively (conductively) extend to the second layer 44 and follow along the path shown (e.g., until reaching another via), where the connection is again made (via the via) to the first layer 42 and the winding repeats itself. As mentioned above, the first and second layers 42 and 44, as well as the individual strands, are electrically isolated from one another due to an intervening insulating material 52, as shown by the two-layer, flex PCB based litz winding structure 40a (similar to the two-layer flex PCB based litz winding structure 40, except with the presentation of the insulating material 52 shown in FIG. 5B). As described above, the insulating material 52 may have a thickness according to a range of approximately 1 mil to 10 mils between layers, enabling effective and efficient heat dissipation from a heat source (e.g., the coil). Note that although FIGS. 5A-5B illustrate plural strands configured in a single turn in each layer, in some embodiments, there may be additional turns (e.g., for two turns, by duplication of the plural strands depicted in FIGS. 5A-5B, such as positioned adjacent to the presently depicted group of strands in each layer along the x-direction). Additionally or alternatively, there may be additional layers of multiple strands (e.g., in the y-direction) and/or a different quantity of strands.

It is noted that the distance between layers has a correspondence to proximity effect and the current distribution along each layer. For instance, for a given current passing through rigid PCB based coil structures, it is observed that, due to proximity effect, the current distribution is not really uniform, which leads to different amount of losses in each layers as well as an increased loss number. This proximity effect is dependent on the distance between the layers. In the case of a rigid PCB based litz winding structure, the minimum distance between the layers is close to 10 mil, which results in higher proximity losses in the windings. In contrast, for a flex PCB based litz winding structure, since the distance between the layers may be reduced to 1 mil, the total losses in the windings may be reduced for the same current magnitude and frequency.

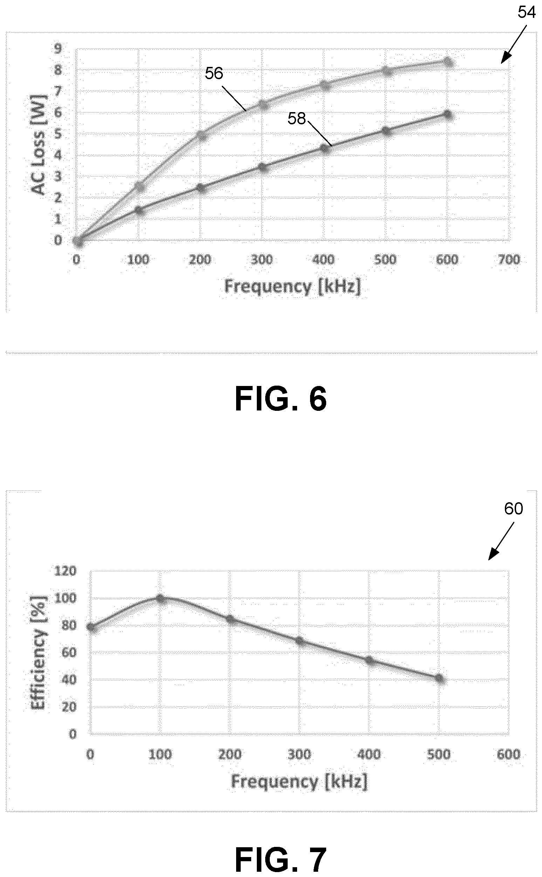

FIG. 6 shows a chart diagram 54. The chart diagram 54 shows an example of total losses in an example rigid PCB based litz winding structure and an example flex PCB based litz winding structure for a current of 150 A and different frequencies. In particular, the chart diagram 54 is shown with a vertical axis for AC losses (W) as a function of frequency (kHz), the latter along the horizontal axis. The example rigid PCB based litz winding structure contains a total of eight layers, and four turns. Each winding path is divided into six conductors in the same layer for two layers forming an intertwined litz winding structure. The distance between the individual layers is kept at 10 mils, which is the minimum that may be achieved in a rigid PCB based litz winding structure. However, for the example flex PCB based litz winding structure of the same quantity of strands and layers, the distance between the individual layers may be reduced to 1 mil. The curve 56 shows the total losses in the example rigid PCB based litz winding structure, and the curve 58 shows the total losses in the example flex PCB based litz winding structure, when a current of 150 A is passed through the respective windings at different frequencies ranging from DC to 600 kHz. As observed, the DC losses for both the structures are unchanged, but the losses due to the high frequency component is much less in case of the flex PCB based litz winding structure as compared to the rigid PCB based litz winding structure. Further, for flex PCB based litz winding structures, design considerations may include balancing dissipating heat from the inner windings (e.g., for layer quantities of 10-15) against the reduction in AC losses, since lower losses typically means lower cooling demands or requirements.

FIG. 7 shows a chart diagram 60 based on the performance illustrated in FIG. 6. The chart diagram 60 has a vertical axis for efficiency (in percent) and a horizontal axis in frequency (kHz). The chart diagram shows an example of percentage reduction of losses in the flex PCB based litz winding structure as compared to the rigid PCB based litz winding structure for the performance associated with FIG. 6. It is observed that the flex PCB based litz winding structure exhibits approximately half the losses when operated at frequencies close to 200 kHz, which makes it ideal for operation in this frequency range as compared to rigid PCB based litz winding structures.

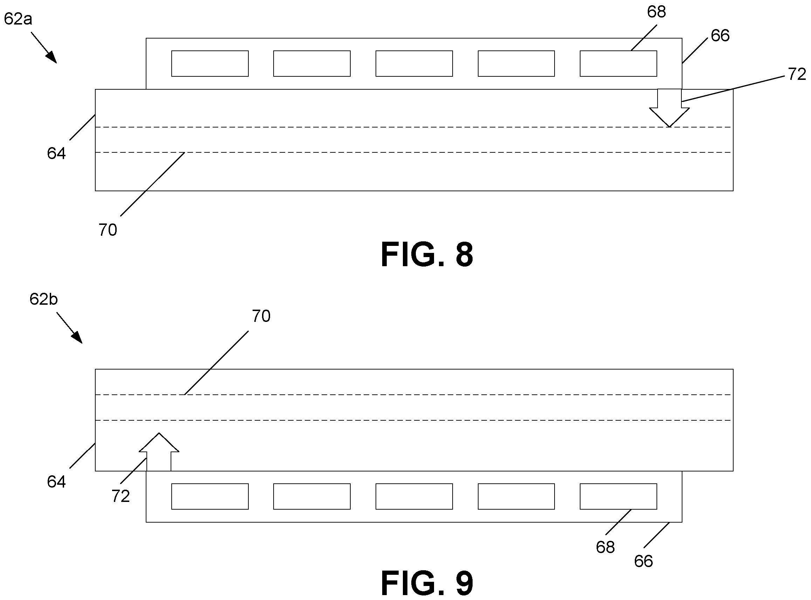

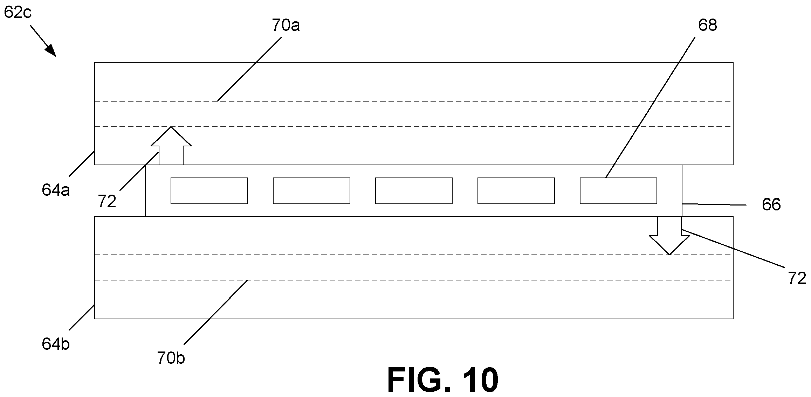

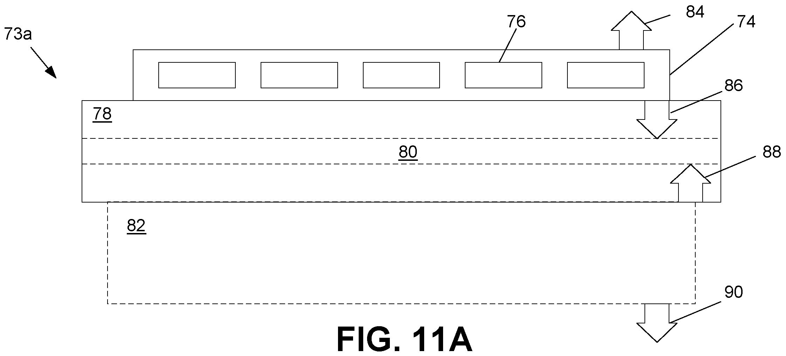

Having described some differences between flex PCB based litz winding structures and rigid PCB based litz winding structures, attention is directed to certain embodiments of example WPT assemblies that combine the flex PCB based litz winding structures with a ceramic heat sink (which may also be referred to as a cold plate) as illustrated in FIGS. 8-10. The WPT assemblies of FIGS. 8-10 may be used in WPT systems (e.g., WPT system 10 of FIG. 1A). The example assemblies described in association with FIGS. 8-10 are particularly suited to wireless power transfer in electric vehicle charging applications. In the description that follows, the various flex PCB based litz winding structures described above may be used as part of the disclosed assemblies in FIGS. 8-10. Such assemblies may be used in any combination in a WPT system. For instance, an assembly such as shown in FIG. 8 may be used in a transmitting unit and an assembly as shown in FIG. 9 or FIG. 10 may be used in a receiving unit, or vice versa. Additionally, FIGS. 11A-17 illustrate various rigid PCB based litz winding structures for non-wireless applications, and include, in addition to the litz winding as a heat source, a ferrite core as a heat source.

Digressing briefly, the addition of the ceramic heat sink is deployed as a heat dissipation (e.g., cooling solution) for efficient heat transfer from a heat source, such as a litz winding (and in applications where a ferrite core structure is used, the ferrite core represents a heat source as well). In some embodiments, the heat source may be from other components or devices. For instance, the heat source may be other components that are co-located in the transmitting unit (e.g., transmitting unit 12, FIG. 1A) with the flex PCB based litz winding structure, including components on a separate PCB (e.g., containing circuitry of the input stage 15) or components that are temporarily in close proximity to the flex PCB based litz winding structure (e.g., components of the receiving unit, such as when a vehicle in which the receiving unit resides is driven to a charging station in which the transmitting unit resides). In these instances, the ceramic heat sink may be used to transfer heat away from such sources. The ceramic heat sink disclosed herein may be made with various kinds of ceramic materials, and in some embodiments, may be manufactured in a manner that permits a fluid-carrying channel or channels (e.g., tubes, pipes, conduit, etc.) inside the ceramic heat sink structure, through which fluid may flow (e.g., under a controlled pressure or gravity flow) to facilitate a heat dissipation effect (e.g., cooling). The position of the ceramic heat sink may be manipulated based on design requirements. The ceramic heat sink may provide the required, or needed, insulation while improving thermal dissipation when compared to metal based heat sinks. For instance, the magnetic fields produced by the windings do not create additional losses on the ceramic heat sink since the ceramic heat sink is electrically insulating, unlike metal based heat sinks. There are essentially no eddy current losses on the ceramic cold plate. Thermal models of at least some of the disclosed assemblies show that the heat from heat sources (e.g., litz windings and, where applicable, the ferrite core) may be dissipated effectively using the ceramic heat sink. The ceramic heat sink offers a low resistance path for the heat path and helps maintain the temperature of the heat sources within nominal values. In effect, proper arrangement of the ceramic heat sink relative to the litz winding may lead to better cooling and less thermal stress on the litz winding (and where applicable, the ferrite cores, among other heat sources proximal to the ceramic heat sink).

Beginning with the description of WPT assemblies for, illustratively, electric vehicle charging and FIGS. 8-10, FIG. 8 shows an embodiment of an example wireless power transfer (WPT) assembly 62a, where a ceramic heat sink 64 is disposed (positioned and/or connected or in contact) beneath, and adjacent to, a flex PCB based litz winding structure 66 (also referred to herein as a flex PCB structure, flex PCB, or the like) comprising a heat source (e.g., litz windings) 68. For instance, the PCB may be extended along a given plane, and the ceramic heat sink 64 may be mounted to the PCB using screws or other fastening mechanisms. The flex PCB based litz winding structure 66 is comprised of flexible insulating material (e.g., flexible insulating layer 34 of FIG. 3, or flexible insulating material 52 of FIG. 5B), which comprises the structural material of the PCB. In the depicted example, the ceramic heat sink 64 further comprises a fluid-carrying channel 70 to facilitate heat transfer away from the heat source 68. The fluid may be water or glycol, for instance. The arrangement or quantity of fluid-carrying channels 70 may be different than the example illustration in FIG. 8 (or similarly, different than the depiction in FIGS. 9-17), or in some embodiments, the fluid-carrying channel 70 may be omitted. An arrow 72 signifies a heat flow path, which in this example, is simply from the heat source 68 (e.g., the litz winding) to the ceramic heat sink 64.

FIG. 9 shows another embodiment of an example WPT assembly 62b, where the ceramic heat sink 64 (with fluid-carrying channel 70) is disposed above and adjacent to the flex PCB based litz winding structure 66. As similarly described above for FIG. 8, the channel 70 may be omitted in these WPT assemblies (or other assemblies, such as shown in FIGS. 11A-17) disclosed herein in some embodiments. The arrow 72 signifies a heat flow path, which again, is from the heat source 68 (e.g., the litz winding) to the ceramic heat sink 64.

FIG. 10 shows yet another embodiment of an example WPT system or assembly 62c, where the flex PCB based litz winding structure 66 is sandwiched between two ceramic heat sinks 64 (e.g., 64a, 64b, with in the depicted embodiment, a corresponding fluid-carrying channel 70a, 70b) disposed above and beneath, and adjacent to, the flex PCB based litz winding structure 66. Fluid may be provided by a single source and diverted (e.g., using a valve) to the respective fluid-carrying channels 70a, 70b, or each fluid-carrying channel 70a, 70b may be sourced separately. The arrows 72 signify, respectively, a heat flow path from the heat source 68 (e.g., the litz winding) to the respective ceramic heat sinks 64a,64b.

Depending on actual design requirements, a wireless power transmission system may implement the same or different embodiments of FIGS. 8-10 at the transmitting unit and/or the receiving unit. Also, the ceramic heat sink 64 may dissipate heat for components other than the WPT assemblies (e.g., 62a, 62b, and/or 62c). For example, the ceramic heat sink 64 may also conduct heat generated by the power converter or neighboring electric components inside the electric vehicle.

As explained above, the disclosed embodiments of a system or assembly that includes a PCB based litz winding structure plus ceramic heat sink are not limited to flex PCB based litz winding structures or WPT applications. FIGS. 11A-17 illustrate system or assembly embodiments that may use a rigid PCB based litz winding structure in various wired applications that involve power transfer and include a ferrite core. Note that reference herein to being disposed adjacent to, or between, another structure or structures is understood to refer to a structure that is positioned adjacent to, and also connected (e.g., via screw or clamp attachment, and/or optionally using a thermal conductive material) directly to, another structure or structures.

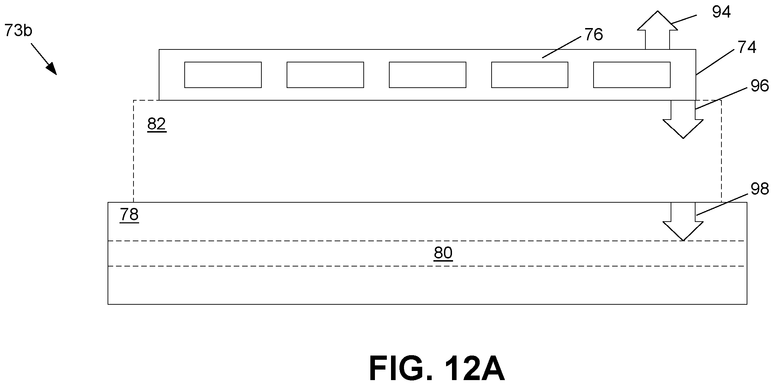

FIG. 11A shows an embodiment of an example assembly 73a where a ceramic heat sink 78 is disposed between a PCB based litz winding structure 74 and a ferrite core 82 (the ferrite core 82 delineated at least in part using dashed lines). For instance, the ceramic heat sink 78 may be connected to the ferrite core 82 via screws or clamps, where a thermal interface material may be used between the ferrite core 82 and the ceramic heat sink 78 to improve the thermal conductivity (e.g., heat transfer). Similar to the description above for WPT applications, and also applicable to the example assemblies illustrated in FIGS. 12A-17, the PCB based litz winding structure 74 includes a heat source 76, which includes the litz winding(s). The PCB based litz winding structure 74 is comprised of a PCB material that is rigid (e.g., a rigid insulating material, such as FR4). In one embodiment, the ceramic heat sink 78 comprises one or more fluid-carrying channels (e.g., one fluid-carrying channel 80 shown). In some embodiments, the ceramic heat sink 78 omits the fluid-carrying channel(s) 80 (in FIG. 11A, as well as for FIGS. 12A-17).

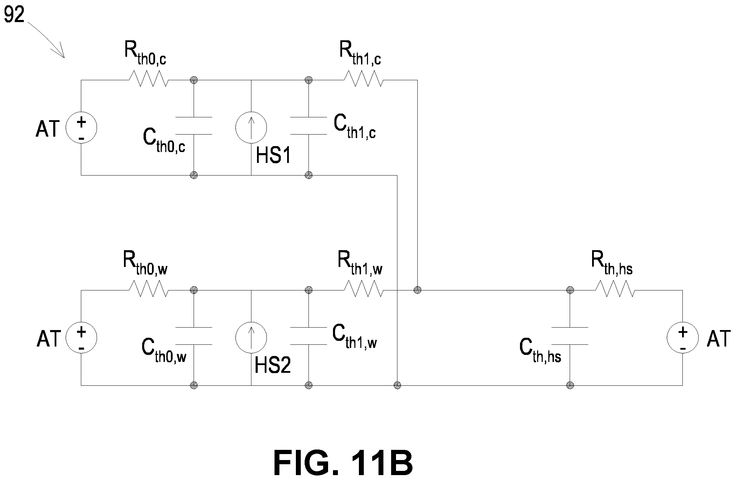

Also shown in FIG. 11A are several arrows 84, 86, 88 and 90 representing heat flow. For instance, and proceeding from top to bottom in FIG. 11A, arrow 84 represents a minor heat flow path (from the heat source 76). Arrow 86 represents a major heat flow path from the heat source 76 to the ceramic heat sink 78. Arrow 88 represents a major heat flow path from the ferrite core 82 to the ceramic heat sink 78. Arrow 90 represents a minor heat flow path from the ferrite core 82 to ambient (air). As similarly described in association with FIG. 8 above, the assembly 73a represents a thermal solution (as compared to applications with metal heat sinks) since the magnetic fields produced by the winding(s) (heat source 76) do not create additional losses on the ceramic heat sink 78 since the ceramic heat sink 78 is electrically insulating, unlike metal based heat sinks. There are essentially no eddy current losses on the ceramic heat sink 78. A thermal model (see FIG. 11B) of the assembly 73a shows that the heat from both the depicted heat sources (the heat source 76 associated with the windings and the ferrite core 82) can be dissipated effectively from the ceramic heat sink 78. The ceramic heat sink 78 offers a low resistance path for the heat path and helps maintain the temperature of the heat sources within nominal values.

FIG. 11B shows an example thermal resistance model or network 92 of the example assembly 73a of FIG. 11A. The thermal resistance network 92 includes several parameters that are explained as follows: AT (ambient temperature), HS1 (heat source associated with ferrite core), HS2 (heat source associated with windings), C_{th0,c} (thermal capacitance of ferrite core, bottom side), R_{th0,c} (thermal resistance between ferrite core and ambient, bottom side), C_{th0,w} (thermal capacitance of PCB winding, top side), R_{th0,w} (thermal resistance between PCB winding and ambient, top side), C_{th1,c} (thermal capacitance of ferrite core, top side), R_{th1,c} (thermal resistance between ferrite core and heat sink, top side), C_{th1,w} (thermal capacitance of PCB winding, bottom side), R_{th1,w} (thermal resistance between PCB winding and heat sink, bottom side side), C_{th,hs} (thermal capacitance of heat sink), R_{th,hs} (thermal resistance between heat sink and ambient). As explained above, the ceramic heat sink 78 is electrically insulating, unlike metal based heat sinks, hence there are essentially no eddy current losses on the ceramic heat sink 78, and the heat source associated with heat sink is omitted in the thermal resistance network 92.

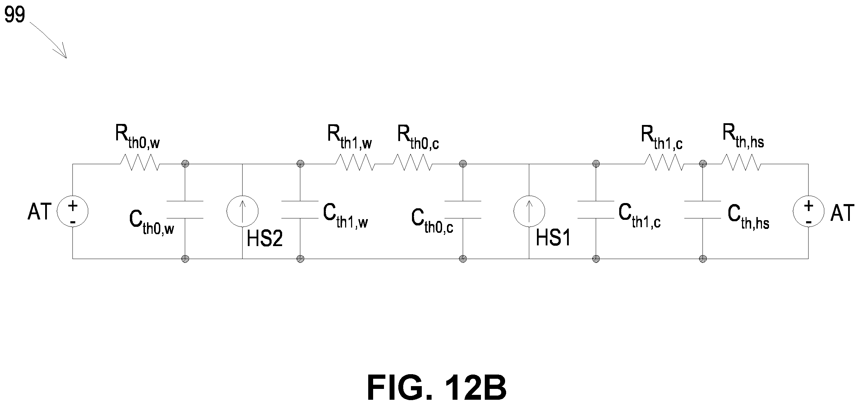

FIG. 12A shows an embodiment of an example assembly 73b where the ceramic heat sink 78 is disposed away from the PCB based litz winding structure 74 and connected to the ferrite core 82. Stated otherwise, the ferrite core 82 is sandwiched in between the PCB based litz winding structure 74 and the ceramic heat sink 78. Arrows representing the heat flows are explained below, proceeding from top to bottom in FIG. 12A. Arrow 94 represents a minor heat flow path (from the heat source 76 and the ferrite core 82). Arrow 96 represents a major heat flow path from heat source 76 to the ferrite core 82. Arrow 98 represents a major heat flow path from the ferrite core 82 to the ceramic heat sink 78. A thermal model (see FIG. 12B) shows that the heat from the heat source 76 flows through the ferrite core 82 (which has its own thermal resistance) and then to the ceramic heat sink 78.

FIG. 12B shows an example thermal resistance model or network 99 of the example assembly 73b of FIG. 12A. The thermal resistance network 99 includes several parameters that are explained as follows: AT (ambient temperature), HS 1 (heat source associated with ferrite core), HS2 (heat source associated with windings), C_{th0,w} (thermal capacitance of PCB winding, top side), R_{th0,w} (thermal resistance between of PCB winding and ambient, top side), C_{th1,w} (thermal capacitance of PCB winding, bottom side), R_{th1,w} (thermal resistance between PCB winding and ferrite core, bottom side), C_{th0,c} (thermal capacitance of ferrite core, top side), R_{th0,c} (thermal resistance between ferrite core and PCB winding, top side), C_{th1,c} (thermal capacitance of ferrite core, bottom side), R_{th1,c} (thermal resistance between ferrite core and heat sink), C_{th,hs} (thermal capacitance of heat sink), R_{th,hs} (thermal resistance between heat sink and ambient).

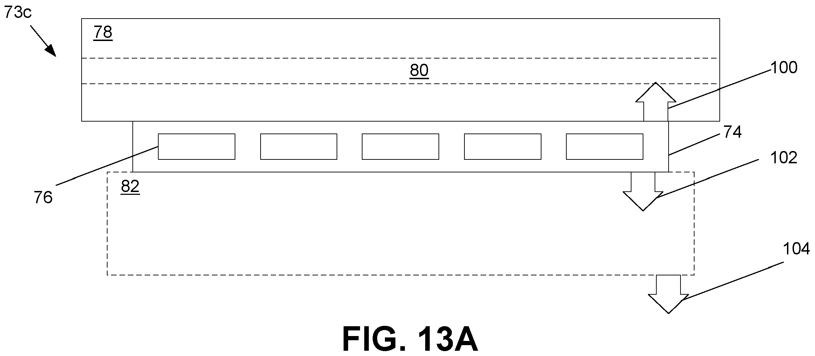

FIG. 13A shows an embodiment of an example assembly 73c where the ceramic heat sink 78 is directly connected to the PCB based litz winding structure 74, away from a ferrite core 82. Here the ceramic heat sink 78 is directly connected to the winding structure (heat sink 76) and the heat may be extracted effectively from the windings. Arrows representing the heat flows are explained below, proceeding from top to bottom in FIG. 13A. Arrow 100 represents a major heat flow path (from the heat source 76). Arrow 102 represents a minor heat flow path from the heat source 76. Arrow 104 represents a major heat flow path from the ferrite core 82. The assembly 73c may be useful in cases where the total loss in the windings is greater than that from the ferrite core 82, or when it is important (e.g., critical) to maintain the temperature of the windings within reasonable limits (as compared to the ferrite core 82). Since the ceramic heat sink 78 is directly connected to the winding structure without another heat source feeding into the ceramic heat sink 78, the ceramic heat sink 78 provides better thermal management for the winding structure.

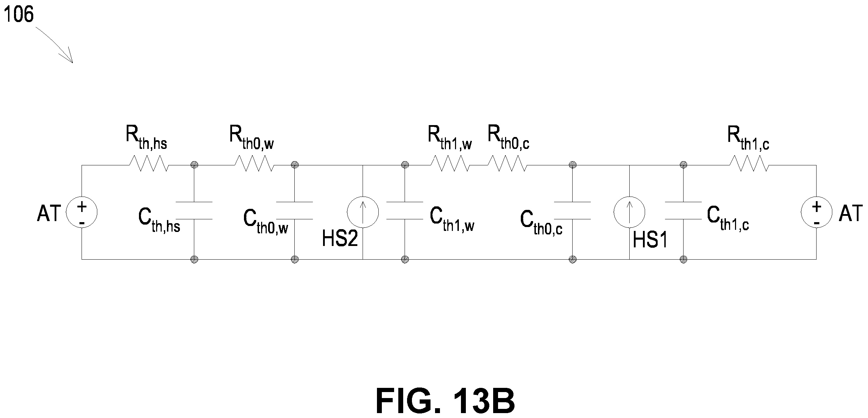

FIG. 13B shows an example thermal resistance model or network 106 of the example assembly 73c of FIG. 13A. The thermal resistance network 106 includes several parameters that are explained as follows: AT (ambient temperature), HS 1 (heat source associated with ferrite core), HS2 (heat source associated with windings), C_{th0,w} (thermal capacitance of PCB winding, top side), R_{th0,w} (thermal resistance between of PCB winding and heat sink, top side), C_{th1,w} (thermal capacitance of PCB winding, bottom side), R_{th1,w} (thermal resistance between PCB winding and ferrite core, bottom side), C_{th0,c} (thermal capacitance of ferrite core, top side), R_{th0,c} (thermal resistance between ferrite core and PCB winding, top side), C_{th1,c} (thermal capacitance of ferrite core, bottom side), R_{th1,c} (thermal resistance between ferrite core and ambient), C_{th,hs} (thermal capacitance of heat sink), R_{th,hs} (thermal resistance between heat sink and ambient, bottom side). It is evident from the thermal resistance network 106 that the effective thermal resistance seen by the PCB based litz winding structure 74 is low, and hence serves as a good approach to maintain the temperature of the winding structure within reasonable limits, provided the ferrite core 82 does not suffer from large losses.

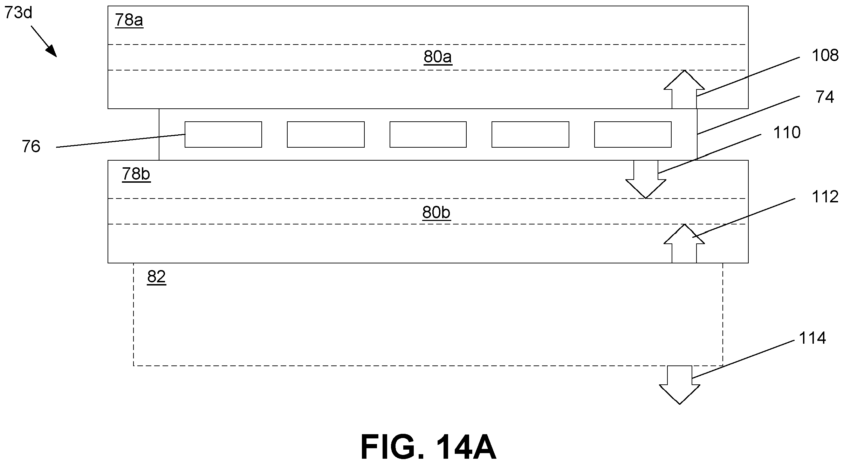

FIG. 14A shows an embodiment of an example assembly 73d where one ceramic heat sink 78a is directly connected to a side of the PCB based litz winding structure 74 away from the ferrite core 82 and another ceramic heat sink 78b is connected to the other side of the PCB based litz winding structure 74 and connected to the ferrite core 82. In other words, the ceramic heat sink 78b is sandwiched in between the PCB based litz winding structure 74 and the ferrite core 82. In a sense, the assembly 73d is an extension of assembly 73c. Arrows representing the heat flows are explained below, proceeding from top to bottom in FIG. 14A. Arrows 108 and 110 represent respective major heat flow paths (from the heat source 76). Arrow 112 represents a major heat flow path from the ferrite core 82. Arrow 114 represents a minor heat flow path from the ferrite core 82.

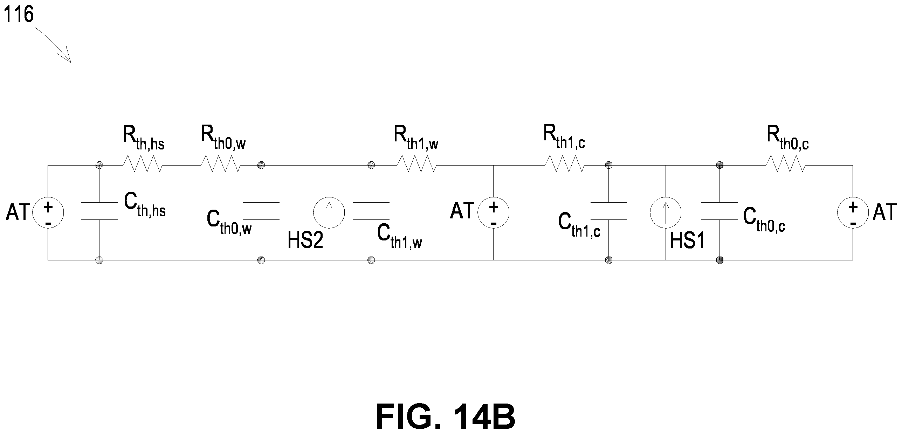

FIG. 14B shows an example thermal resistance model or network 116 of the example assembly 73d of FIG. 14A. The thermal resistance network 116 includes several parameters that are explained as follows: AT (ambient temperature), HS 1 (heat source associated with ferrite core), HS2 (heat source associated with windings), C_{th0,c} (thermal capacitance of the ferrite core, bottom side), R_{th0,c} (thermal resistance between the ferrite core and ambient, bottom side), C_{th0,c} (thermal capacitance of PCB winding, top side), R_{th0,w} (thermal resistance between PCB winding and heat sink, top side), C_{th1,c} (thermal capacitance of ferrite core, top side), R_{th1,c} (thermal resistance between ferrite core and heat sink, top side), C_{th1,w} (thermal capacitance of PCB winding, bottom side), R_{th1,w} (thermal resistance between PCB winding and heat sink, bottom side), C_{th,hs} (thermal capacitance of heat sink), R_{th,hs} (thermal resistance between heat sink and ambient).

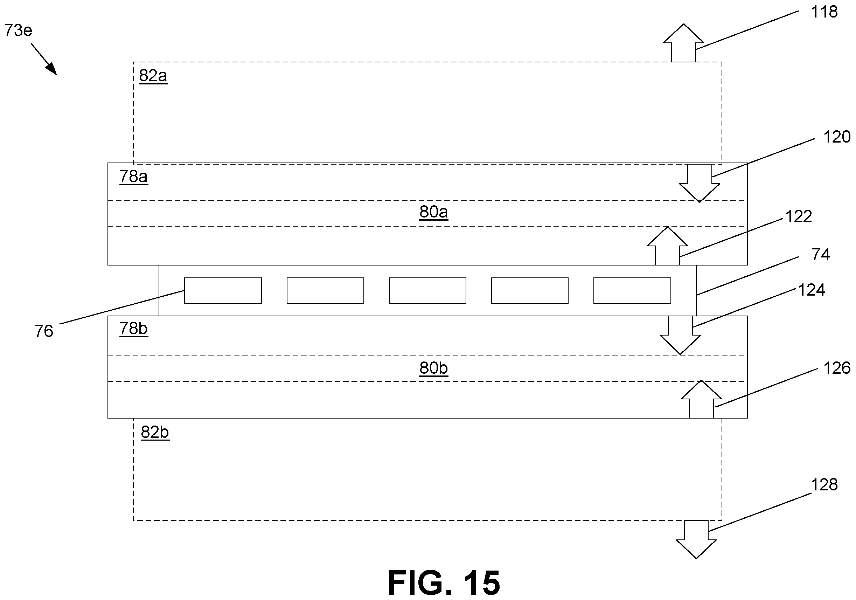

FIG. 15 shows an embodiment of an example assembly 73e where the PCB based litz winding structure 74 is sandwiched in between the ceramic heat sinks 78a and 78b (similar to the assembly 73d in FIG. 14A) and directly connected to the ceramic heat sink 78. One side of the ceramic heat sink 78a not adjacent to the PCB based litz winding structure 74 is adjacent to, and connected to, the ferrite core (82a). Another side of the ceramic heat sink 78b not adjacent to the PCB based litz winding structure 74 is adjacent to, and connected to, an additional ferrite core (82b). Arrows representing the heat flows are explained below, proceeding from top to bottom in FIG. 15. Arrow 118 represents a minor heat flow path from the ferrite core 82a (top core). Arrow 120 represents a major heat flow path from the ferrite core 82a (top core). Arrows 122 and 124 represent respective major heat flow paths from the heat source 76. Arrow 126 represents a major heat flow path from the ferrite core 82b (bottom core). Arrow 128 represents a minor heat flow path from the ferrite core 82b (bottom core). It is noted that the assembly 73e may be used for conventional transformer-based structures. In this case, the ferrite cores 82a and 82b are present on either side of the winding structure enclosing the same. The ceramic heat sinks 78a and 78b may be used to cool the winding structure from both directions, thus offering improved thermal management. In this case, the ferrite cores 82a and 82b are also connected to the ceramic heat sinks 78a and 78b, which helps in thermal dissipation in the ceramic heat sinks 78a and 78b.

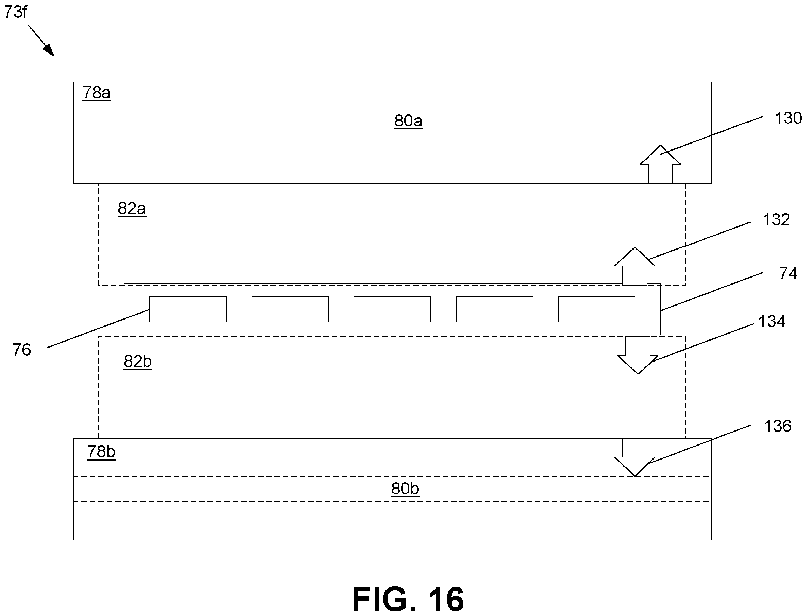

FIG. 16 shows an embodiment of an example assembly 73f where the PCB based litz winding structure 74 is sandwiched between the ceramic heat sinks 78a and 78b and directly connected to the ferrite cores 82a and 82b. One side of the ferrite core 82a not adjacent to the PCB based litz winding structure 74 is adjacent to, and connected to, the ceramic heat sink (78a). Another side of the ferrite core 82b not adjacent to the PCB based litz winding structure 74 is adjacent to, and connected to, an additional heat sink 78b. Arrows representing the heat flows are explained below, proceeding from top to bottom in FIG. 16. Arrow 130 represents a major heat flow path from the ferrite core 82a (top core). Arrow 132 represents a major heat flow path from the heat source 76. Arrow 134 represents a major heat flow path from the heat source 76. Arrow 136 represents a minor heat flow path from the ferrite core 82b (bottom core). In this case, the cooling of the ferrite cores 82a and 82b are carried out in a more effective fashion since the ceramic heat sinks 78a and 78b are directly connected to the ferrite cores 82a and 82b itself. This structure may be used in applications where a coupled transformer is implemented.

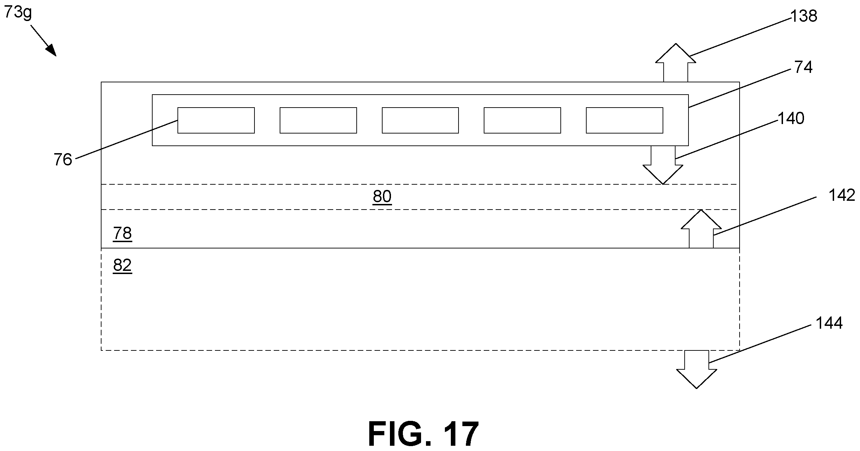

FIG. 17 shows an embodiment of an example assembly 73g where the PCB based litz winding structure 74 is integrated into the ceramic heat sink 78 (e.g., a single piece structure), with the ferrite core 82 adjacent to, and connected directly to, the ceramic heat sink 78. Arrows representing the heat flows are explained below, proceeding from top to bottom in FIG. 17. Arrow 138 represents a minor heat flow path from the heat source 76. Arrow 140 represents a major heat flow path from the heat source 76. Arrow 142 represents a major heat flow path from the ferrite core 82. Arrow 144 represents a minor heat flow path from the ferrite core 82. For these structures, conventional FR4 materials may be used, or materials with higher thermal conductivity may be used, including kapton, mylar, or even ceramic-based PCBs. In such structures, cooling pipes may be embedded to provide the necessary cooling for the PCB based litz winding structure 74 and the ferrite core 82. The assembly 73g may be extended to all the other structures disclosed in association with FIGS. 11A-16.

Having described certain embodiments a system and assembly that includes a printed circuit board (PCB) based litz winding or coil structure and ceramic heat sink, and with reference to at least FIGS. 3, 5A-5B, and 8-10, it should be appreciated that one embodiment of an example wireless power transfer assembly (62) includes a flexible printed circuit board (66) including a litz winding (68), the litz winding having multiple layers (32) of electrically insulated strands; and a ceramic heat sink (64) arranged relative to the flexible printed circuit board in a manner that dissipates heat away from the litz winding.

The embodiment of the example wireless power transfer assembly may include any one or a combination of the following features.

For the embodiment of the example wireless power transfer assembly, the flexible printed circuit board includes a flexible insulating material (34), wherein at least two layers (32a, 32b) of the multiple layers are separated by the flexible insulating material, the flexible insulating material disposed between the at least two layers including a minimum thickness within a range of approximately 1 mil to 10 mil.

For the embodiment of the example wireless power transfer assembly, the flexible insulating material is comprised of one of polyester, an adhesive polyamide, or an adhesiveless polyamide.

For the embodiment of the example wireless power transfer assembly, the litz winding is comprised of a bendable, electrically conductive material.

For the embodiment of the example wireless power transfer assembly, the litz winding is comprised of an annealed copper.

For the embodiment of the example wireless power transfer assembly, the litz winding is comprised of the electrically insulated strands that are connected in a spiral or helical manner.

For the embodiment of the example wireless power transfer assembly, a first layer (42) and a second layer (44) of the multiple layers of the electrically insulated strands are connected using vias (50).

For the embodiment of the example wireless power transfer assembly, the ceramic heat sink includes one or more fluid-carrying channels (70).

For the embodiment of the example wireless power transfer assembly, the ceramic heat sink is in contact with the flexible printed circuit board, the ceramic heat sink arranged adjacent to the flexible printed circuit board.

For the embodiment of the example wireless power transfer assembly, further including an additional ceramic heat sink, wherein the certain heat sink and the additional ceramic heat sink are in contact with the flexible printed circuit board, the ceramic heat sink arranged adjacent to one side of the flexible printed circuit board and the additional ceramic heat sink arranged adjacent to another side of the flexible printed circuit board.

With reference to at least FIGS. 1A, 3, 5A-5B, and 8-10, it should be appreciated that one embodiment of an example wireless power transfer system (10) includes a transmit unit or receive unit (12) having an input stage (15), a resonator (16), and an assembly (62), the assembly including: a flexible printed circuit board (66) having a litz winding (68), the litz winding having multiple layers (32) of electrically insulated strands; and a ceramic heat sink (64) arranged relative to the flexible printed circuit board in a manner that dissipates heat away from the litz winding.

The embodiment of the example wireless power transfer system may include any one or a combination of the following features.

For the embodiment of the example wireless power transfer system, the flexible printed circuit board includes a flexible insulating material (34), wherein at least two layers (32a, 32b) of the multiple layers are separated by the flexible insulating material, the flexible insulating material disposed between the at least two layers including a minimum thickness within a range of approximately 1 mil to 10 mil.

For the embodiment of the example wireless power transfer system, the flexible insulating material is comprised of one of polyester, an adhesive polyamide, or an adhesiveless polyamide.

For the embodiment of the example wireless power transfer system, the litz winding is comprised of a bendable, electrically conductive material.

For the embodiment of the example wireless power transfer system, the assembly operates in a range of approximately 90 kHz to 200 kHz.

For the embodiment of the example wireless power transfer system, the litz winding is comprised of the electrically insulated strands that are connected in a spiral or helical manner.

For the embodiment of the example wireless power transfer system, a first layer (42) and a second layer (44) of the multiple layers of the electrically insulated strands are connected using vias (50).

For the embodiment of the example wireless power transfer system, the ceramic heat sink includes one or more fluid-carrying channels (70).

For the embodiment of the example wireless power transfer system, the ceramic heat sink is in contact with the flexible printed circuit board, the ceramic heat sink arranged adjacent to the flexible printed circuit board.

For the embodiment of the example wireless power transfer system, further including an additional ceramic heat sink, wherein the certain heat sink and the additional ceramic heat sink are in contact with the flexible printed circuit board, the ceramic heat sink arranged adjacent to one side of the flexible printed circuit board and the additional ceramic heat sink arranged adjacent to another side of the flexible printed circuit board.

Having described certain embodiments of an assembly that includes a rigid printed circuit board (PCB) based litz winding or coil structure and ceramic heat sink, and with reference to at least FIGS. 11A-17, it should be appreciated that one embodiment of an example assembly (72) includes a rigid printed circuit board based litz winding structure (74), the rigid printed circuit board based litz winding structure comprised of a rigid insulating material; a ferrite core (82); and a ceramic heat sink (78) disposed relative to the printed circuit board based litz winding structure and the ferrite core in a manner that dissipates heat.

The embodiment of the example assembly may include any one or a combination of the following features.

For the embodiment of the example assembly, the ceramic heat sink includes one or more fluid carrying channels (80).

For the embodiment of the example assembly, the ceramic heat sink is disposed between, and adjacent to, the rigid printed circuit board based litz winding structure and the ferrite core.

For the embodiment of the example assembly, the ferrite core is disposed between, and adjacent to, the PCB based litz winding structure and the ceramic heat sink.

For the embodiment of the example assembly, the PCB based litz winding structure is disposed between, and adjacent to, the ceramic heat sink on one side of the PCB based litz winding structure and the ferrite core on another side of the PCB based litz winding structure.

For the embodiment of the example assembly, the PCB based litz winding structure is disposed between, and adjacent to, the ceramic heat sink (78a) on one side of the PCB based litz winding structure and another ceramic heat sink (78b) on the other side of the PCB based litz winding structure, the another ceramic heat sink (78b) connected to and adjacent the ferrite core on a side opposite the side connected to the PCB based litz winding structure.

For the embodiment of the example assembly, the PCB based litz winding structure is sandwiched between the ceramic heat sinks, wherein one side of the ceramic heat sink 78a not adjacent to the PCB based litz winding structure 74 is adjacent to, and connected to, the ferrite core (82a), and another side of the ceramic heat sink 78b not adjacent to the PCB based litz winding structure 74 is adjacent to, and connected to, an additional ferrite core (82b).

For the embodiment of the example assembly, the PCB based litz winding structure is sandwiched in between the ceramic heat sink, wherein one side of the ceramic heat sink 78a not adjacent to the PCB based litz winding structure 74 is adjacent to, and connected to, the ferrite core (82a), and another side of the ceramic heat sink 78b not adjacent to the PCB based litz winding structure 74 is adjacent to, and connected to, an additional ferrite core (82b).

For the embodiment of the example assembly, the PCB based litz winding structure is integrated into the ceramic heat sink, and the ceramic heat sink is adjacent to, and connected to, the ferrite core.

## Claims

1. A wireless power transfer assembly (62a), **characterized by** comprising:
a flexible printed circuit board (66, 28) comprising a litz winding (30), the litz winding (30) having multiple layers (32a, 32b, 32c, 32d) of electrically insulated strands (38); and
a ceramic heat sink (64) arranged relative to the flexible printed circuit board (66) in a manner that dissipates heat away from the litz winding.

2. The wireless power transfer assembly (62a) of claim 1, wherein the flexible printed circuit board (28) comprises a flexible insulating material (34), wherein at least two layers of the multiple layers (32a, 32b, 32c, 32d) are separated by the flexible insulating material (34), the flexible insulating material (34) disposed between the at least two layers comprising a minimum thickness within a range of approximately 1 mil to 10 mil.

3. The wireless power transfer assembly (62a) of claim 2, wherein the flexible insulating material (34) is comprised of one of polyester, an adhesive polyamide, or an adhesiveless polyamide.

4. The wireless power transfer assembly (62a) of claim 1, wherein the litz winding (30) is comprised of a bendable, electrically conductive material.

5. The wireless power transfer assembly (62a) of claim 4, wherein the litz winding (30) is comprised of an annealed copper.

6. The wireless power transfer assembly (62a) of claim 1, wherein the litz winding (30) is comprised of the electrically insulated strands (38) that are connected in a spiral or helical manner.

7. The wireless power transfer assembly (62a) of claim 1, wherein a first layer (42) and a second layer (44) of the multiple layers of the electrically insulated strands (46) are connected using vias (50).

8. The wireless power transfer assembly (62a) of claim 1, wherein the ceramic heat sink (64) comprises one or more fluid-carrying channels (70).

9. The wireless power transfer assembly (62a) of claim 1, wherein the ceramic heat sink (64) is in contact with the flexible printed circuit board (66), the ceramic heat sink (64) arranged adjacent to the flexible printed circuit board (66).

10. The wireless power transfer assembly (62c) of claim 1, further comprising an additional ceramic heat sink, wherein the certain heat sink (64a) and the additional ceramic heat sink (64b) are in contact with the flexible printed circuit board (66), the ceramic heat sink (64a) arranged adjacent to one side of the flexible printed circuit board (66) and the additional ceramic heat sink (64b) arranged adjacent to another side of the flexible printed circuit board (66).

11. A wireless power transfer system (10), **characterized by** comprising:
a transmit unit (12) or receive unit (14) having an input stage (15), a resonator (16), and an assembly (62a), the assembly (62a) comprising:
a flexible printed circuit board (66, 28) having a litz winding (30), the litz winding (30) having multiple layers (32a, 32b, 32c, 32d) of electrically insulated strands (38); and
a ceramic heat sink (64) arranged relative to the flexible printed circuit board (66) in a manner that dissipates heat away from the litz winding.

12. The wireless power transfer system (10) of claim 11, wherein the flexible printed circuit board (28) comprises a flexible insulating material (34), wherein at least two layers of the multiple layers (32a, 32b, 32c, 32d) are separated by the flexible insulating material (34), the flexible insulating material (34) disposed between the at least two layers comprising a minimum thickness within a range of approximately 1 mil to 10 mil.

13. The wireless power transfer system (10) of claim 12, wherein the flexible insulating material (34) is comprised of one of polyester, an adhesive polyamide, or an adhesiveless polyamide.

14. The wireless power transfer system (10) of claim 11, wherein the litz winding (30) is comprised of a bendable, electrically conductive material.

15. The wireless power transfer system (10) of claim 11, wherein the assembly (62a) operates in a range of approximately 90 kHz to 200 kHz.

16. The wireless power transfer system (10) of claim 11, wherein the litz winding (30) is comprised of the electrically insulated strands (38) that are connected in a spiral or helical manner.

17. The wireless power transfer system (10) of claim 11, wherein a first layer (42) and a second layer (44) of the multiple layers of the electrically insulated strands (46) are connected using vias (50).

18. The wireless power transfer system (10) of claim 11, wherein the ceramic heat sink (64) comprises one or more fluid-carrying channels (70).

19. The wireless power transfer system (10) of claim 11, wherein the ceramic heat sink (64) is in contact with the flexible printed circuit board (66), the ceramic heat sink (64) arranged adjacent to the flexible printed circuit board (66).

20. The wireless power transfer system (10) of claim 11, further comprising an additional ceramic heat sink, wherein the certain heat sink (64a) and the additional ceramic heat sink (64b) are in contact with the flexible printed circuit board (66), the ceramic heat sink (64a) arranged adjacent to one side of the flexible printed circuit board (66) and the additional ceramic heat sink (64b) arranged adjacent to another side of the flexible printed circuit board (66).
